# EUROPEAN PATENT APPLICATION

(11) **EP 4 787 000 A1**
(43) Date of publication of application: **05.08.2026**
(21) Application number: 25382060.9
(22) Date of filing: 31.01.2025
(51) Int. Cl.: G01R 31/58, H04L 43/50, H04B 3/46

(54) **SYSTEM AND ASSOCIATED METHOD FOR AUTOMATIC WIRING DIAGNOSTICS AND MONITORING**

(71) Applicant: González-Zuazo Contreras, Emilio, 28016 Madrid (ES)
(72) Inventor: González-Zuazo Contreras, Emilio, 28016 Madrid (ES); Reina Acedo, Rafael, 28210 Valdemorillo, Madrid (ES)
(74) Representative: Ballester Cañizares, Rosalia

(57) **Abstract**

The invention relates to a system and associated method for automatic wiring diagnostics and monitoring comprising a control computer (1), head-end (2) and remote (3) terminals, a switching matrix, isolation relays (2b), driver and measurement circuits, and a database (4). The control computer (1) manages the tests by means of TCP/IP protocols, connecting and processing data from the terminals. The head-end (2) and remote (3) terminals incorporate a light indicator associated with each connector that allows immediate visual identification of the connections. The switching matrix allows communication lines to be dynamically connected to signal generators, measurement or load modules, ensuring flexibility and symmetry in tests. Isolation relays (2b) ensure safety by disconnecting lines from external devices, while remote terminals (3) simulate real operating conditions and collect data. The database (4) stores results for analysis and generating reports, facilitating preventive maintenance and scalability of the system.

## Description

### Object of the invention

The object of the present specification is a system and associated method for automatic wiring diagnostics and monitoring in complex installations, such as auditoriums, stadiums, and industrial environments. This system allows performing full tests of communication lines by means of a modular set of equipment that ensures a safe, precise and efficient operation.

### Background of the invention

At present, the maintenance and diagnostics of wiring systems represents a considerable technical challenge in modern large-scale installations such as auditoriums, stadiums, hospitals or data centres. The complexity of these installations resides in factors such as the length of the communication lines, the coexistence of different types of wiring, adverse environmental conditions and the need to ensure continuous and reliable operation.

Traditional systems for checking the state of wiring have multiple limitations. These methods usually rely on manual processes that require the intervention of specialised technical personnel to perform continuity, resistance or attenuation tests. This approach is not only slow and costly, but also highly prone to human error, which can lead to incorrect diagnostics and failures in the detection of critical problems. In addition, manual execution significantly increases system downtime, which is particularly problematic in environments where availability is critical.

Another important limitation of traditional systems is their limited ability to analyse complex configurations or manage multiple lines of communication simultaneously. These systems lack automation, which restricts their effectiveness in large installations and makes them difficult to scale to adapt to growing or changing infrastructures. Likewise, conventional systems usually lack suitable mechanisms to ensure the safety of connected external equipment during the tests, which generates significant risks of damage to critical devices.

Finally, existing methods do not offer effective integration with modern data analysis tools or predictive maintenance systems. This limits their ability to identify patterns of degradation or anticipate failures before they become serious problems.

The present invention addresses these drawbacks by means of a fully automated system and method that not only eliminate dependence on manual processes, but also offers an advanced capability for precise, reproducible and safe diagnostics in complex environments. Thanks to its modular design, the system easily adapts to different wiring configurations, ensuring a scalable and versatile solution for diagnostics and maintenance needs in modern installations.

### Description of the Invention

The technical problem solved by the present invention is to ensure automatic, safe and efficient wiring diagnostics in complex installations, eliminating the need for slow and error-prone manual processes, as well as significantly improving the analysis capacity and scalability of existing systems, allowing adaptation to different wiring configurations and operating environments thanks to the immediate detection and communication of anomalies in real time, improving the response capacity in critical installations.

The system herein proposed addresses these issues by means of a modular set of components that work together to automate the checking of communication lines and provide reliable and reproducible results. For this purpose, the system and associated method for automatic wiring diagnostics and monitoring, which is the object of the present invention, is characterised by comprising at least one control computer, head-end and remote terminals, a switching matrix, isolation relays, driver and measurement circuits and a database.

To this end, the control computer acts as the operational brain of the system, running software that coordinates all operations, from the configuration of the tests to the generation of reports. This computer manages communication with the head-end terminals by means of TCP/IP protocols (Transmission Control Protocol/Internet Protocol) with the connected terminals, using data connections (Ethernet, WiFi, telephony or satellite) to guarantee stability and speed in data transfer. It is configured to process in real time the data received from the head-end and remote terminals, analysing critical parameters such as impedance, resistance, induced noise, light power, bit rate, error rate and attenuation. If anomalies are detected during tests, the computer generates automatic alerts that can **be** sent to external devices such as mobile phones, supervising systems or remote control platforms. In addition, it organises the results obtained in a database, allowing detailed analysis and integration into automated reports.

The head-end and remote terminals work together to run the tests. The head-end terminals are responsible for generating the test signals and analysing the responses by means of advanced, deliberately designed driver and measurement circuits. These signals are distributed through a switching matrix that ensures flexibility and symmetry in the connections. Remote terminals simulate real operating conditions using load modules in terminal equipment, record responses of the line and transmit the collected data to the control computer for processing. Additionally, the system can include a junction box configured to centralise and manage all communication lines in the installation. This box facilitates the connection of lines to head-end and remote terminals, providing a modular and scalable interface that reduces the time required for initial configuration and improves the scalability of the system by allowing the incorporation of new lines without altering the main structure. Furthermore, both the head-end and remote terminals have a visual indicator, such as LEDs, which light up the corresponding connection points when a cable is selected in the control computer. The need for coordination between several operators to physically locate the ends of each cable is thereby eliminated, optimising installation times and minimising errors.

Thanks to its design, the switching matrix, integrated in the head-end terminal, allows the communication lines to be dynamically connected to signal generators, measurement modules or loads, ensuring precise and interference-free tests. This design ensures that the system is adaptable to various configurations and test types, allowing it to be expanded to handle a larger number of lines in large-scale installations. Furthermore, its modular architecture facilitates the incorporation of new wiring technologies, such as hybrid or fibre optic-based lines, ensuring compatibility with future system updates. In addition, isolation relays, also present in the head-end terminal, automatically disconnect the lines of external devices before starting the tests, protecting both the connected equipment and the system itself.

Driver and measurement circuits generate programmable signals with specific characteristics (such as frequency and voltage) and analyse critical parameters of lines, including impedance, resistance, induced noise, bit rate, error rate, light power and attenuation. These circuits are modular, allowing them to be updated or extended to incorporate new types of measurements as needed.

The remote terminal, located at the opposite end of the wiring, interfaces with the signals generated by the head-end terminal. This terminal includes load modules that simulate real operating conditions and measurement devices that capture responses of the line. The data collected by the remote terminal are transmitted to the control computer for analysis and storage.

The system also allows possible interferences and faults in the installation to be precisely identified by means of injecting a test signal into a specific line which allows the responses against all the other lines in the group, i.e. those that have been laid next to it, to be simultaneously analysed. This iterative process is carried out systematically for each line in the set, which involves a high volume of cross-measurements. In configurations where line groups are extensive, this functionality is essential to detect wiring errors, unintentional shunts, shielding failures that can lead to high levels of induced noise, as well as phase reversals between symmetrical conductors. The system's ability to analyse multiple lines in parallel ensures a comprehensive evaluation of the wiring, facilitating early identification of anomalies and optimising preventive maintenance processes.

Finally, the database centralises the information generated during the tests. It stores configurations, historical results and trend analysis, facilitating early fault detection and the planning of preventive maintenance tasks. In addition, this database can be integrated with advanced predictive maintenance systems based on artificial intelligence or machine learning. These systems process stored historical data, identify patterns of degradation in communication lines and generate automated alerts that allow potential failures to be anticipated, thereby optimising resource management and reducing downtimes.

In addition, the system has an auxiliary mode of operation aimed at facilitating wiring validation and management in operational installations. Traditionally, the identification and connection of a cable in a complex system requires the intervention of at least two technicians, one in the head-end terminal and one in the remote terminal, which must communicate to locate the ends of each cable before proceeding with the connection. In this system, the cables are located automatically, allowing the user to select a cable on the control computer interface or on a portable display, immediately lighting up the corresponding connectors on the terminals, speeding up the task and reducing human error.

In a second aspect of the invention, the method associated with the present invention for automatic wiring diagnostics and monitoring comprises the following steps:
- In a first step, the tests are configured from the control computer, setting the parameters of the test signals, such as frequency, voltage and type of analysis, by means of specialised software that allows the selection of specific lines and configurations.
- In a second step, isolation relays disconnect the lines from external devices, ensuring the safety of the process.
- In a third step, the driver circuits in the head-end terminal generate programmable signals that are sent to the selected lines by means of the switching matrix, which ensures flexibility and symmetry in the connections.
- In a fourth step, the remote terminals simulate real operating conditions by applying specific loads and record the responses of the lines being tested.
- In a fifth step, the collected data are transmitted to the control computer, where they are processed and compared with reference values. If the system detects anomalies in the analysed parameters, such as significant deviations from the expected values, it generates automatic alerts. These alerts can be sent immediately to external devices, such as mobile phones, supervising systems or remote control platforms, using secure communication protocols.
- In a sixth and final step, the results obtained are stored in the database, generating detailed reports that allow possible failures to be identified, trends to be analysed and preventive maintenance tasks to be planned.

The system and associated method presented herein represent a comprehensive solution for wiring diagnostics, combining advanced technology, complete automation and a scalable architecture that makes it an indispensable tool in modern and complex installations.

### Brief description of the figures

A very brief description of a series of drawings that aid in better understanding the invention, and which are expressly related to an embodiment of said invention that is presented by way of a non-limiting example of the same, is provided below.
- Figure 1: shows a general scheme of the system, object of the present invention, implemented in a typical installation.
- Figure 2: shows a second general scheme of the system, object of the present invention, implemented in a typical installation.

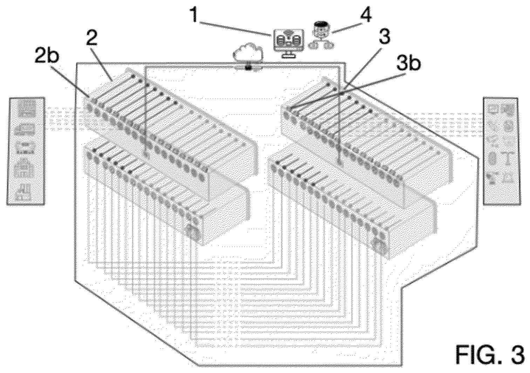

- Figure 3: shows in detail the structure of a head-end terminal (2) and a remote terminal (3).

### Description of a detailed embodiment of the invention

A preferred embodiment of the invention is shown in the attached figures. More specifically, the system and associated method of automatic wiring diagnostics and monitoring is characterised in that it comprises a set of integrated components that work in synergy to ensure efficient and safe operation. They include a control computer (1), running software for managing tests, collecting data and generating reports by means of TCP/IP protocols, connected through data (Ethernet, WiFi, telephony or satellite) and fibre optic connections; a head-end terminal (2), in turn including a switching matrix, configured to connect any communication line to signal generators, measurement modules or loads, thus ensuring flexibility and symmetry in tests, isolation relays (2b), configured to disconnect lines from external devices during the tests, thereby ensuring safety and protection during the tests; driver and measurement circuits, configured to generate programmable test signals and analyse parameters such as impedance, resistance, induced noise, light power, bit rate, error rate and attenuation; a remote terminal (3), including at least a load module and connection to communication lines; and a database (4), configured to store configurations, historical results and trend analysis of test results.

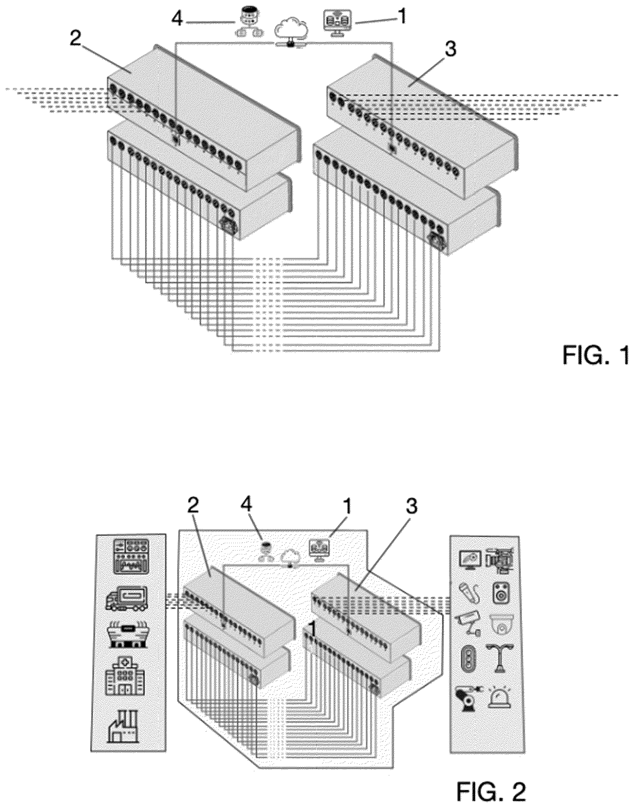

In a first practical embodiment, as shown in Figure 2, the head-end terminal (2) contains the switching matrix, the driver and measurement circuits, and the isolation relays (2b). This configuration allows the lines to be tested to be selected by means of the control computer (1) which sends specific commands through data connections (Ethernet, WiFi, telephony or satellite). The switching matrix connects the lines to signal generators or measurement modules, ensuring that each test is accurate and reproducible. In addition, this matrix is designed with high-speed relays to ensure rapid changes between configurations without interference.

The remote terminal (3), as can be observed in the figures, is installed at the opposite end of the wiring to be diagnosed. This terminal includes load elements that simulate real operating conditions and allow the response of the lines to be analysed. The collected data are sent to the control computer (1) for analysis and storage in the database (4).

The switching matrix allows any line to be connected to the measurement or signal generation modules in a flexible and symmetrical manner. This ensures that the system is adaptable to various configurations and operational requirements. In addition, the isolation relays (2b) act as protective barriers, disconnecting the lines from external devices to prevent possible damage or interference during tests.

In a second practical embodiment, the system can be configured for distributed testing, where several remote terminals (3) are simultaneously connected to a single head-end terminal (2). This configuration is useful in large-scale installations, such as stadiums or industrial sites, where multiple lines need to be tested in parallel. In this case, the control computer (1) synchronously manages all interactions between the terminals, ensuring that the tests are performed efficiently and accurately.

In a third practical embodiment, the system incorporates LED signalling functionality, which significantly improves wiring operating capacity and maintenance. For this purpose, each connection point at the head-end terminal (2) and the remote terminal (3) has an indicator system made up of LED indicators located under each connector. This function allows automatic identification of the ends of a cable when it is selected on the screen of the control computer (1) or on a portable device. The system lights up the corresponding LED at both ends of the selected line, facilitating the rapid connection and reducing human error during installation or maintenance.

By way of illustration, the operational process would be as follows: The system starts with the configuration of tests from the control computer (1), followed by the activation of the isolation relays (2b) to disconnect the lines from the external devices. The test signals are then generated by means of the driver circuits and the results are analysed in real time thanks to the data provided by the remote terminal (3). Finally, the results are processed and stored in the database (4), generating detailed reports that aid in fault detection and preventive maintenance. Additionally, in a step prior to the start of the tests, the installation's communication lines are connected to the system through a junction box designed to organise and centralise the connections. This box allows easy identification and selection of the lines to be tested, directing them to the head-end and remote terminals in an orderly and modular manner. This design simplifies the initial connection process and ensures more efficient operation, especially in large-scale installations.

## Claims

1. A system for automatic wiring diagnostics and monitoring, **characterised by** comprising at least:
a control computer (1), running software for managing tests, collecting data and generating reports by means of TCP/IP protocols, connected through data (Ethernet, WiFi, 3G, 4G or 5G) and fibre optic connections;
at least one head-end terminal (2), in turn including
a switching matrix, configured to connect any communication line to signal generators, measurement modules or loads, thus ensuring flexibility and symmetry in tests,
isolation relays (2b) configured to disconnect lines from external devices during tests, thus ensuring safety and protection in tests;
driver and measurement circuits configured to generate programmable test signals and analyse parameters such as impedance, resistance, induced noise, light power, bit rate, error rate and attenuation;
at least one remote terminal (3), including at least isolation relays (3b), a load module and connection to communication lines;
a database (4) configured to store configurations, historical results and trend analysis of test results.

2. The system for automatic wiring diagnostics and monitoring according to claim 1, wherein the remote terminals (3) are configured to operate in a distributed manner and connect simultaneously to a single head-end terminal (2) in large-scale installations.

3. The system for automatic wiring diagnostics and monitoring according to claims 1 to 2, wherein the control computer (1) includes software configured to customise tests and provide interactive user interfaces.

4. The system for automatic wiring diagnostics and monitoring according to claims 1 to 3, wherein the driver and measurement circuits are modular.

5. The system for automatic wiring diagnostics and monitoring according to claims 1 to 4, wherein the control computer (1) is configured to process in real time the data received from the head-end terminals (2) and the remote terminals (3), automatically detecting anomalies in the communication lines by means of integrated analysis algorithms, and generating and sending automatic alerts to external devices, such as mobile phones or tablets, supervision systems or remote control platforms by means of standard communication protocols.

6. The system for automatic wiring diagnostics and monitoring according to claims 1 to 5, wherein the database (4) is configured to be integrated with predictive maintenance systems based on artificial intelligence or machine learning, allowing the analysis of historical test results, identifying degradation patterns in the communication lines and optimising the planning of preventive maintenance tasks.

7. The system for automatic wiring diagnostics and monitoring according to claims 1 to 6, wherein both the head-end terminals (2) and the remote terminals (3) have a light indicator associated with each connector, said light indicators being configured to light up automatically at both ends of the selected line when it is identified in the control computer (1) or in a portable device.

8. The system for automatic wiring diagnostics and monitoring according to claims 1 to 7, including a junction box configured to centralise and organise the installation's communication lines, facilitating their connection to the head-end and remote terminals.

9. A method for automatic wiring diagnostics and monitoring, **characterised in that** it comprises the steps of:
configuring tests from the control computer (1) by setting the parameters of the test signals through specialised software;
disconnecting the lines of external devices by means of isolation relays (2b), ensuring the safety of the connected equipment;
generating programmable test signals by means of driver circuits located in the head-end terminal (2), sending them to selected lines through a switching matrix;
applying real operating conditions by means of load modules in remote terminals (3), measuring the responses of the lines being tested;
transmitting the collected data from the remote terminals (3) to the control computer (1), where it is processed and compared with previously stored reference values;
storing the results obtained in a database (4), generating detailed reports for fault detection, trend analysis and preventive maintenance planning.

## Amended claims

### Amended claims in accordance with Rule 137(2) EPC.

1. A system for automatic wiring diagnostics and monitoring, **characterised by** comprising at least:
a control computer (1), running software for managing tests, collecting data and generating reports by means of TCP/IP protocols, connected through data (Ethernet, WiFi, 3G, 4G or 5G) and fibre optic connections;
at least one head-end terminal (2), in turn including
a switching matrix, configured to connect any communication line to signal generators, measurement modules or loads, thus ensuring flexibility and symmetry in tests,
isolation relays (2b) configured to disconnect lines from external devices during tests, thus ensuring safety and protection in tests;
driver and measurement circuits configured to generate programmable test signals and analyse parameters such as impedance, resistance, induced noise, light power, bit rate, error rate and attenuation;
at least one remote terminal (3), including at least isolation relays (3b), a load module and connection to communication lines;
a database (4) configured to store configurations, historical results and trend analysis of test results;
and wherein both the head-end terminals (2) and the remote terminals (3) have a light indicator associated with each connector, said light indicators being configured to light up automatically at both ends of the selected line when it is identified in the control computer (1) or in a portable device.

2. The system for automatic wiring diagnostics and monitoring according to claim 1, wherein the remote terminals (3) are configured to operate in a distributed manner and connect simultaneously to a single head-end terminal (2) in large-scale installations.

3. The system for automatic wiring diagnostics and monitoring according to claims 1 to 2, wherein the control computer (1) includes software configured to customise tests and provide interactive user interfaces.

4. The system for automatic wiring diagnostics and monitoring according to claims 1 to 3, wherein the driver and measurement circuits are modular.

5. The system for automatic wiring diagnostics and monitoring according to claims 1 to 4, wherein the control computer (1) is configured to process in real time the data received from the head-end terminals (2) and the remote terminals (3), automatically detecting anomalies in the communication lines by means of integrated analysis algorithms, and generating and sending automatic alerts to external devices, such as mobile phones or tablets, supervision systems or remote control platforms by means of standard communication protocols.

6. The system for automatic wiring diagnostics and monitoring according to claims 1 to 5, wherein the database (4) is configured to be integrated with predictive maintenance systems based on artificial intelligence or machine learning, allowing the analysis of historical test results, identifying degradation patterns in the communication lines and optimising the planning of preventive maintenance tasks.

7. The system for automatic wiring diagnostics and monitoring according to claims 1 to 6, including a junction box configured to centralise and organise the installation's communication lines, facilitating their connection to the head-end and remote terminals.

8. A method for automatic wiring diagnostics and monitoring, **characterised in that** it comprises the steps of:
configuring tests from the control computer (1) by setting the parameters of the test signals through specialised software;
disconnecting the lines of external devices by means of isolation relays (2b), ensuring the safety of the connected equipment;
generating programmable test signals by means of driver circuits located in the head-end terminal (2), sending them to selected lines through a switching matrix;
applying real operating conditions by means of load modules in remote terminals (3), measuring the responses of the lines being tested;
transmitting the collected data from the remote terminals (3) to the control computer (1), where it is processed and compared with previously stored reference values;
storing the results obtained in a database (4), generating detailed reports for fault detection, trend analysis and preventive maintenance planning.
